# EUROPÄISCHE PATENTANMELDUNG

(11) **EP 1 993 199 A2**
(43) Veröffentlichungstag der Anmeldung: **19.11.2008**
(21) Anmeldenummer: 08008706.7
(22) Anmeldetag: 09.05.2008
(51) Int. Cl.: H03B 5/12

(54) **Oszillator mit magnetischer Kopplung**

(30) Priorität: 15.05.2007 DE 102007022999
(71) Anmelder: ATMEL Duisburg GmbH, 47057 Duisburg (DE)
(72) Erfinder: El Rai, Samir, Colorado Springs, CO 80906 (US)
(74) Vertreter: Koch Müller Patentanwaltsgesellschaft mbH

(57) **Zusammenfassung**

Oszillator, mit:
- einer Mehrzahl von Anregungseinrichtungen (301, 303, 321, 323, 325, 501, 503) zum Bereitstellen eines Anregungssignals und
- einem Tank als Schwingungserzeugungseinrichtung zum Erzeugen eines Oszillationssignals ansprechend auf das Anregungssignal,
- wobei der Tank Anschlüsse (AN, AP) zum Bereitstellen des Oszillatorsignals aufweist,
- wobei jede Anregungseinrichtung (301, 303, 321, 323, 325, 501, 503) zumindest eine Induktivität (L4, L6) aufweist,
- wobei der Tank mit der zumindest einen Induktivität (L4, L6) jeder Anregungseinrichtungen (301, 303, 321, 323, 325, 501, 503) magnetisch gekoppelt ist,
- wobei das Anregungssignal zwischen den Anregungseinrichtungen (301, 303, 321, 323, 325, 501, 503) und dem Tank mittels der magnetischen Kopplungen übertragbar ist.

## Beschreibung

Die vorliegende Erfindung betrifft das Gebiet der Schwingungserzeugung.

In vielen Systemen der Nachrichtentechnik werden lokale Oszillatoren benötigt, welche beispielsweise als spannungsgesteuerte Oszillatoren eingesetzt werden (VCO; Voltage Controlled Oscillator). Diese Oszillatoren generieren ein Oszillatorsignal, das sowohl zum Heruntermischen als auch zum Heraufmischen eines empfangenen bzw. eines zu sendenden Signals benötigt wird.

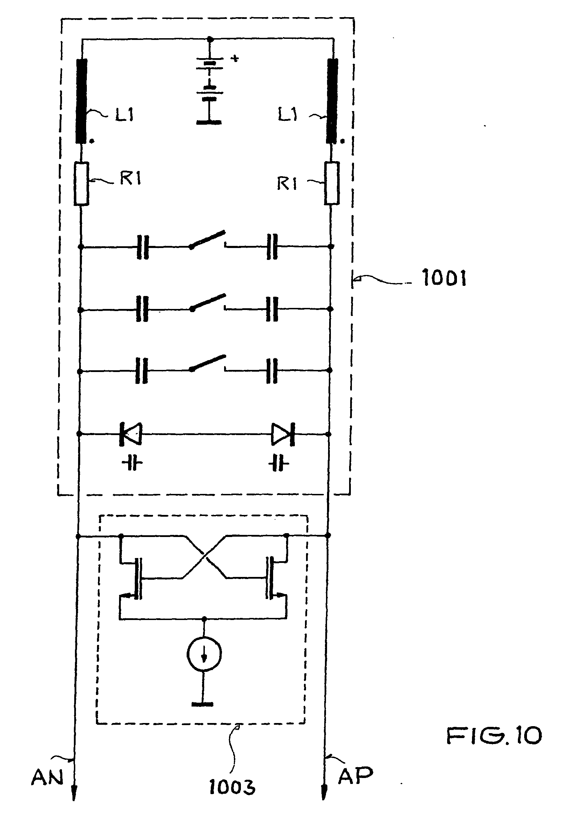

Fig. 10 zeigt eine VCO-Schaltung, die hauptsächlich aus zwei Schaltungseinheiten besteht. Die erste Schaltungseinheit 1001 ist ein Tank (LC-Schwingkreis), der für die Schwingungserzeugung vorgesehen ist. Die zweite Schaltungseinheit 1003 ist ein Verstärker, der den Tank anregt.

Die Signalqualität des Oszillators beeinflusst die Qualität eines Nachrichtenübertragungssystems maßgeblich. Die wichtigsten Eigenschaften eines VCOs sind dessen spektrale Reinheit, dessen Ausgangsleistung und dessen Leistungseffizienz. Ein Maß für die Spektrale Reinheit eines Ausgangssignals eines Oszillators ist das Phasenrauschen PN (Phase Noise).

Das Phasenrauschen ist hauptsächlich von den folgenden Parametern abhängig:
- Qualitätsfaktor des LC-Tankes Q,
- Amplitude A des LC Tankes. Sie ist die Spannungsdifferenz zwischen den in Fig. 10 eingezeichneten Knoten AP und AN beim Schwingen, und
- Rauschen des Verstärkers.

Aus der US 2006/0181355 A1 ist ein Silizium-Bipolar-VCO mit einem doppelt gekoppelten Übertrager bekannt. In der US 7,154,349 B2 ist ein Multi-Band-VCO mit gekoppelten Induktivitäten und mehreren Anschlüssen gezeigt.

Es ist die Aufgabe der Erfindung ein möglichst verbessertes Konzept zur Schwingungserzeugung zu schaffen.

Diese Aufgabe wird durch die Merkmale der unabhängigen Ansprüche gelöst.

Demzufolge ist ein Oszillator mit einer Mehrzahl von Anregungseinrichtungen zum Bereitstellen eines Anregungssignals vorgesehen. Der Oszillator weist einen Tank als Schwingungserzeugungseinrichtung zum Erzeugen eines Oszillationssignals ansprechend auf das Anregungssignal auf. Der Tank weist Anschlüsse zum Bereitstellen des Oszillatorsignals auf. Jede Anregungseinrichtung weist zumindest eine Induktivität auf.

Der Tank ist mit der zumindest einen Induktivität jeder Anregungseinrichtungen magnetisch gekoppelt. Das Anregungssignal ist zwischen den Anregungseinrichtungen und dem Tank mittels der magnetischen Kopplungen übertragbar.

Bevorzugt wird ein effizientes Konzept zur Schwingungserzeugung durch die Übertragung der Anregungsenergie über eine magnetische Kopplung zwischen einer Anregungseinrichtung, z.B. einem Verstärker, und einer Schwingungserzeugungseinrichtung, z.B. einem Tank, erreicht.

Eine Steigerung der Amplitude wird vorteilhafterweise unabhängig von den vorstehend genannten Faktoren erreicht. Gleichzeitig kann eine optimale Betriebsamplitude und Betriebsumgebung der aktiven Bauelemente (z.B. der Anregungseinrichtung) erreicht werden, was zu einem besseren Rausch- und Leistungsverhalten dieser Bauelemente führt.

Die Erfindung schafft einen Oszillator mit einer Anregungseinrichtung, z.B. einem Verstärker, zum Bereitstellen eines Anregungssignals und einer Schwingungserzeugungseinrichtung, z.B. einem Tank, zum Erzeugen eines Oszillationssignals ansprechend auf das Anregungssignal. Das Anregungssignal wird bevorzugt von der Anregungseinrichtung zu der Schwingungserzeugungseinrichtung mittels zumindest einer magnetischen Kopplung übertragen.

Der Oszillator umfasst eine Mehrzahl von Anregungseinrichtungen, wobei jede der Anregungseinrichtungen mit der Schwingungserzeugungseinrichtung zur Übertragung eines Anregungssignals magnetisch koppelbar ist. Die Anregungseinrichtungen liefern somit über eine Mehrzahl von magnetischen Kopplungen (z.B. parallel) die zur Schwingungserzeugung benötigte Energie. Zwischen den Anregungseinrichtungen kann gemäß einer weiteren Ausführungsform jeweils eine magnetische oder kapazitive Kopplung vorgesehen werden.

Jede der Anregungseinrichtungen umfasst zumindest eine Induktivität, wobei die Schwingungserzeugungseinrichtung für jede Anregungseinrichtungen zumindest eine Induktivität aufweist, die der jeweiligen Anregungseinrichtungen zugeordnet ist. Bevorzugt ist jede Induktivität der jeweiligen Anregungseinrichtung sowie die ihr zugeordnete Induktivität der Schwingungserzeugungseinrichtung für jeweils eine magnetische Kopplung vorgesehen.

Ein weiterer Aspekt der Erfindung ist eine Verwendung einer Mehrzahl von Anregungseinrichtungen (301, 303, 321, 323, 325, 501, 503) eines Oszillators zum Bereitstellen eines Anregungssignals aus der Summe von Anregungsenergien der einzelnen Anregungseinrichtungen (301, 303, 321, 323, 325, 501, 503). Der Oszillator ist vorzugsweise wie zuvor erläutert ausgebildet.

Gemäß einer Ausführungsform sind jede Anregungseinrichtung und die Schwingungserzeugungseinrichtung sowohl bezüglich der Gleichspannungssignale als auch bezüglich der Wechselspannungssignale, beispielsweise bezüglich der hochfrequenten Signale, galvanisch voneinander getrennt.

Gemäß einer weiteren Ausführungsform sind jede Anregungseinrichtung und die Schwingungserzeugungseinrichtung bezüglich der Gleichspannungssignale galvanisch gekoppelt (beispielsweise über die Masse) und nur bezüglich der Wechselspannungssignale, beispielsweise bezüglich der hochfrequenten Signale, galvanisch voneinander getrennt.

Gemäß einer weiteren Ausführungsform sind jede Anregungseinrichtung und die Schwingungserzeugungseinrichtung an zumindest einem Knotenpunkt verbunden, bei dem beim Betrieb des Oszillators ein konstantes Potential, insbesondere eine virtuelle Masse, herrscht.

Gemäß einer Ausführungsform weisen jede Anregungseinrichtung und die Schwingungserzeugungseinrichtung jeweils eine Induktivität auf, die magnetisch koppelbar sind. Die magnetische Kopplung wird somit über induktive Elemente, z.B. Spulen oder auch geeignet angeordnete Streifenleitungen, realisiert.

Gemäß einer weiteren Ausführungsform umfasst jede Anregungseinrichtung einen Verstärker, z.B. einen Transistorverstärker, mit zumindest einer Induktivität, die für die magnetische Kopplung mit zumindest einer Induktivität der Schwingungserzeugungseinrichtung vorgesehen ist.

Gemäß einer weiteren Ausführungsform umfasst die Schwingungserzeugungseinrichtung eine LC-Schaltung, die abstimmbar sein kann und abstimmbare Kapazitäten und/oder Induktivitäten aufweisen kann, zur Abstimmung einer Schwingfrequenz des Oszillatorsignals. Dabei kann zumindest eine Induktivität der LC-Schaltung für die magnetische Kopplung vorgesehen werden.

Gemäß einer weiteren Ausführungsform umfasst die Schwingungserzeugungseinrichtung Anschlüsse zum Bereitstellen des Oszillatorsignals, die von der Anregungseinrichtung galvanisch getrennt sind oder an zumindest einem Knotenpunkt verbunden sind, bei dem beim Betrieb des Oszillators ein konstantes Potential, insbesondere eine virtuelle Masse, herrscht. Somit sind der Anregungspfad und der Oszillationspfad voneinander isoliert.

Gemäß einer weiteren Ausführungsform umfasst jede Anregungseinrichtung eine Transistorverstärkerschaltung, eine erste Induktivität und eine zweite Induktivität, wobei die erste und die zweite Induktivität mit der Transistorverstärkerschaltung verbunden sind und für die magnetische Kopplung vorgesehen sind. Ferner umfasst die Schwingungserzeugungseinrichtung eine dritte Induktivität und eine vierte Induktivität, die jeweils für eine magnetische Kopplung vorgesehen sind, wobei die zweite und die vierte Induktivität für eine magnetische Kopplung vorgesehen sind, und wobei die erste und die dritte Induktivität für eine magnetische Kopplung vorgesehen sind. In diesem Fall wird die Anregungsenergie über zwei magnetische Kopplungen übertragen.

Gemäß einer weiteren Ausführungsform sind die erste und die zweite Induktivität über einen Knotenpunkt leitfähig verbunden, an den ein Potential, z.B. das Massepotential, anlegbar ist. Die die dritte und die vierte Induktivität sind dabei beispielsweise in Serie geschaltet.

Gemäß einer weiteren Ausführungsform umfasst jede Anregungseinrichtung zumindest eine Verstärkerschaltung, wobei die Verstärkerschaltung einen ersten Transistor und einen zweiten Transistor umfasst, wobei ein erster Anschluss des ersten Transistors mit einem Steueranschluss des zweiten Transistors verbunden ist und wobei ein erster Anschluss des zweiten Transistors mit einem Steueranschluss des ersten Transistors verbunden ist. Durch diese Kreuzschaltung wird gleichzeitig eine Zusatzkapazität erzeugt, die sich ebenfalls auf die resultierende Schwingfrequenz auswirkt.

Der erste Anschluss des ersten Transistors ist bevorzugt mit einer ersten Induktivität jeder Anregungseinrichtung verbunden, der zweite Anschluss des zweiten Transistors ist bevorzugt mit einer zweiten Induktivität jeder Anregungseinrichtung verbunden und die zweiten Anschlüsse des ersten und des zweiten Transistors sind bevorzugt miteinander verbunden.

Die ersten Anschlüsse können z.B. Drain- oder Source-Anschlüsse der Transistoren sein, wobei die Steueranschlüsse z.B. Gate-Anschlüsse sein können.

Gemäß einer weiteren Ausführungsform umfasst jede Anregungseinrichtung eine erste leitfähige Struktur, z.B. eine Streifenleitung. Die Schwingungserzeugungseinrichtung umfasst eine zweite leitfähige Struktur, z.B. eine Streifenleitung. Dabei sind die erste und die zweite leitfähige Struktur angeordnet, die magnetische Kopplung bereitzustellen. Die leitfähigen Strukturen bilden hierzu z.B. magnetisch koppelbare Induktivitäten.

Gemäß einer weiteren Ausführungsform umfasst zumindest eine der Anregungseinrichtungen eine erste leitfähige Struktur, die von einer zweiten leitfähigen Struktur der Schwingungserzeugungseinrichtung zumindest teilweise umschlossen ist. Beispielsweise formt die zweite leitfähige Struktur, z.B. eine Streifenleitung, eine geöffnete Schleife, innerhalb der die erste leitfähige Struktur angeordnet ist, so dass sich die magnetische Kopplung einstellen kann.

Gemäß einer weiteren Ausführungsform umfasst jede Anregungseinrichtung einen ersten Verstärker und einen zweiten Verstärker, wobei der erste Verstärker und der zweite Verstärker über leitfähige Strukturen, z.B. Streifenleitungen, parallel geschaltet sind. Dabei umfasst die Schwingungserzeugungseinrichtung ebenfalls eine leitfähige Struktur, die für die magnetische Kopplung mit der leitfähigen Struktur der Anregungseinrichtung vorgesehen ist.

Gemäß einer weiteren Ausführungsform sind die leitfähigen Strukturen der Anregungseinrichtung über eine weitere leitfähige Struktur, die beispielsweise einen Steg bildet, leitfähig verbunden.

Gemäß einer weiteren Ausführungsform sind der erste Verstärker und der zweite Verstärker parallel zu der weiteren leitfähigen Struktur geschaltet.

Bevorzugt ist der Oszillator abstimmbar, wobei die Schwingungserzeugungseinrichtung und/oder die Anregungseinrichtung abstimmbare Induktivitäten und/oder Kapazitäten aufweisen können.

Gemäß einer weiteren Ausführungsform umfasst die Schwingungserzeugungseinrichtung zumindest eine leitfähige Struktur, die zumindest eine leitfähige Struktur der Anregungseinrichtung für die magnetische Kopplung, beispielsweise als geöffnete Schleife, zumindest teilweise umschließt.

Gemäß einer weiteren Ausführungsform sind die leitfähigen Strukturen der jeweiligen Anregungseinrichtung zumindest bezüglich der HF-Signale galvanisch getrennt oder an zumindest einem Knotenpunkt, an dem beim Betrieb des Oszillators virtuell ein konstantes Potential, insbesondere virtuelle Masse, herrscht, verbunden.

Gemäß einer weiteren vorteilhaften Ausführungsform sind die Anregungseinrichtungen und/oder die Schwingungserzeugungseinrichtung als differentielle Schaltkreise ausgeführt.

Ein weiterer Aspekt der Erfindung ist eine Verwendung einer Mehrzahl von Anregungseinrichtungen eines Oszillators zum Bereitstellen eines Anregungssignals aus der Summe von Anregungsenergien der einzelnen Anregungseinrichtungen. Der Oszillator ist vorzugsweise wie zuvor erläutert ausgebildet.

In einem Verfahren zur Erzeugung einer Schwingung sind die Schritte des Bereitstellens eines Anregungssignals durch mehrere Anregungseinrichtungen und des Erzeugen eines Oszillationssignals durch eine Schwingungserzeugungseinrichtung ansprechend auf das Anregungssignal, wobei das Anregungssignal zwischen den Anregungseinrichtungen und der Schwingungserzeugungseinrichtung mittels einer magnetischen Kopplung für jede Anregungseinrichtung übertragen wird.

Weitere Verfahrensschritte ergeben sich direkt aus der Funktionalität des Oszillators.

Weitere Ausführungsbeispiele werden Bezug nehmend auf die beiliegenden Zeichnungen beschrieben. Es zeigen:
- Fig. 1: ein Blockdiagramm eines Oszillators;
- Fig. 2: einen Oszillator;
- Fig. 3a und 3b: einen Oszillator;
- Fig. 4a und 4b: einen Oszillator;
- Fig. 5: ein Chipbild eines Oszillators;
- Fig. 6: einen Oszillator;
- Fig. 7: einen Oszillator;
- Fig. 8: einen Oszillator;
- Fig. 9: einen Oszillator; und
- Fig. 10: einen Oszillator.

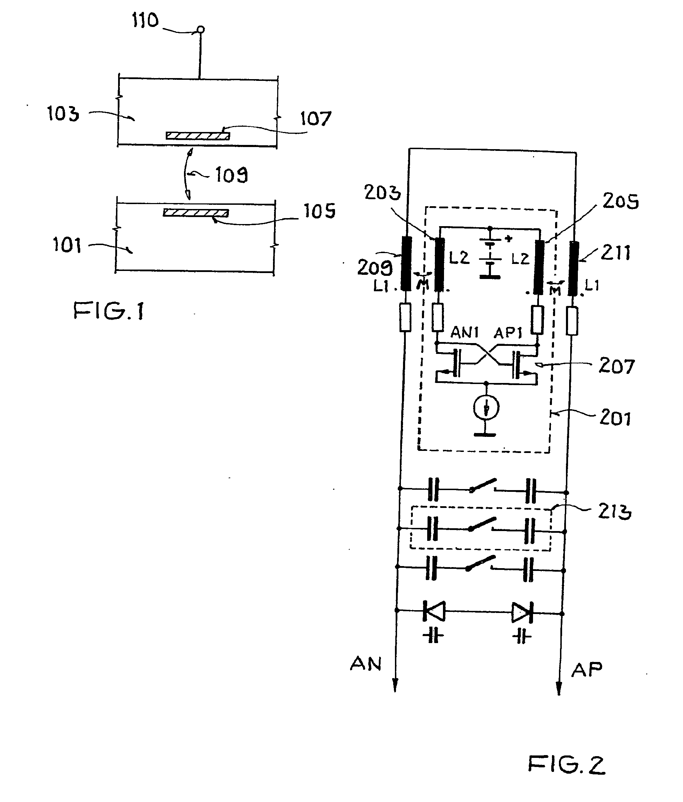

Fig. 1 zeigt ein Blockdiagramm eines Oszillators mit einer Anregungseinrichtung 101 zum Bereitstellen eines Anregungssignals und einer Schwingungserzeugungseinrichtung 103 zum Erzeugen eines Oszillationssignals ansprechend auf das Anregungssignal. Die Anregungseinrichtung 101 weist eine Induktivität 105 auf, der eine Induktivität 107 der Schwingungserzeugungseinrichtung 103 zugeordnet sind. Die Induktivitäten 105 und 107 sind vorgesehen, eine magnetische Kopplung 109 bereitzustellen, über die das Anregungssignal von der Anregungseinrichtung 101 zu der Schwingungserzeugungseinrichtung 103 übertragen wird. Die Schwingungserzeugungseinrichtung 103 umfasst ferner zumindest einen Ausgang 110, an dem das Oszillationssignal bereitgestellt wird.

Fig. 2 zeigt einen Oszillator mit einer Anregungseinrichtung 201, die eine erste Induktivität 203, eine zweite Induktivität 205, eine Transistorverstärkerschaltung 207 umfassend zwei gekoppelte Transistoren und eine mit Masse verbundene Stromquelle sowie zwei Ausgänge AN1 und AP1 umfasst. Der Ausgang AN1 ist über ein optionales resistives Element (z.B. einen optionalen Widerstand) mir der ersten Induktivität 203 gekoppelt, der Ausgang AP1 ist über ein weiteres optionales resistives Element (z.B. einen optionalen Widerstand) mit der zweiten Induktivität 205 gekoppelt. Die Induktivitäten 203 und 205 sind ferner über einen Knotenpunkt verbunden, an den z.B. das Massepotential oder ein anderes Potential (z.B. Vdd) anlegbar ist.

Der Oszillator umfasst ferner eine Schwingungserzeugungseinrichtung mit einer dritten Induktivität 209 und einer vierten Induktivität 211, die mit der dritten Induktivität 209 in Serie geschaltet ist. Die Induktivität 209 ist über ein optionales resistives Element (z.B. einen optionalen Widerstand) mit einem ersten Ausgang AN der Schwingungseinrichtung verbunden, die Induktivität 211 ist über ein optionales resistives Element (z.B. einen optionalen Widerstand) mit einem zweiten Ausgang AP der Schwingungseinrichtung verbunden. Zwischen den Ausgängen AN und AP ist ferner zumindest ein kapazitives Netzwerk 213 geschaltet, das zwei Kapazitäten aufweist, die über einen Schalter in Serie geschaltet sind. Ferner sind zwischen den Ausgängen AN und AP eine Diodenschaltung umfassend zumindest zwei antiseriell geschaltete Dioden, die jeweils eine Kapazität nachbilden, angeordnet.

In dieser Topologie erfolgt die Einkopplung der von den aktiven Bauelementen erzeugten Energie, magnetisch in den Schwingkreis 201. Falls der Wert L2 der Induktivitäten 203 und 205 gleich dem Wert L1 der Induktivitäten 209 und 211 ist und falls die magnetische Kopplung M gleich 1 ist, so erhält man in dieser Topologie die gleichen Eigenschaften wie in der Topologie aus Fig. 10.

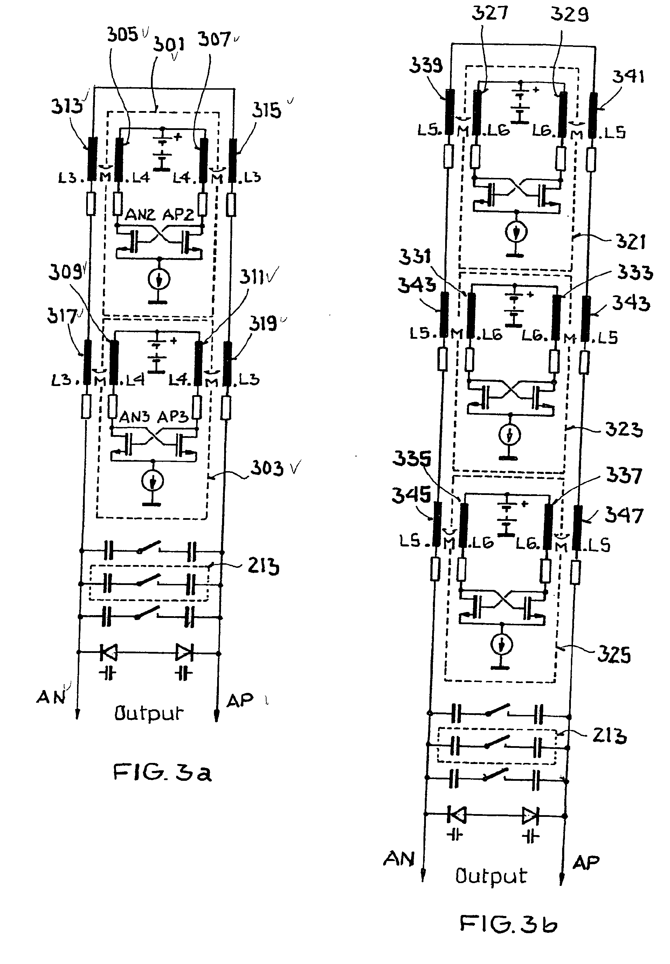

In den Figuren 3a und 3b sind Oszillatoren zur Realisierung eines VCOs mit hohen Amplituden dargestellt.

Fig. 3a zeigt einen Oszillator mit einer ersten Anregungseinrichtung 301 und einer zweiten Anregungseinrichtung 303, deren Strukturen jeweils der Struktur der Anregungseinrichtung 207 aus Fig. 2 entsprechen. Jede Anregungseinrichtung 301 und 303, umfasst eine Transistorverstärkerschaltung mit gekoppelten Transistoren, optionalen resistiven Elementen und einer Stromquelle. Die Anregungseinrichtung 301 umfasst zwei über einen Knotenpunkt, an den ein (virtuelles) Massepotential anlegbar ist, gekoppelte Induktivitäten 305 und 307, die Anregungseinrichtung 303 umfasst zwei über einen Knotenpunkt, an den ein (virtuelles) Massepotential anlegbar ist, gekoppelte Induktivitäten 309 und 311.

Der Oszillator umfasst ferner eine Schwingungserzeugungseinrichtung mit in Serie geschalteten Induktivitäten 313 und 315. Die Induktivität 313 ist über einen optionalen Widerstand mit einer Induktivität 317 gekoppelt, die über einen optionalen Widerstand mit einem ersten Ausgang AN des Oszillators gekoppelt ist. Die Induktivität 315 ist über einen optionalen Widerstand mit einer Induktivität 319 gekoppelt, die über einen optionalen Widerstand mit einem zweiten Ausgang AP gekoppelt ist. Zwischen den Ausgängen AN und AP sind zumindest eine kapazitive Schaltung 213 umfassend zumindest zwei über einen Schalter gekoppelte Kapazitäten sowie eine Diodenschaltung umfassend zwei antiseriell geschaltete Dioden angeordnet.

Die magnetische Kopplung zwischen den Anregungseinrichtungen 301, 303 und der Schwingungserzeugungseinrichtung wird über die Induktivitätenpaare 305 und 313, 307 und 315, 309 und 311 sowie 313 und 319 realisiert.

Ein Vorteil des Ausführungsbeispiels der Fig. 3a ist, dass der DC-Betriebsstrom für die Transistoren der Anregungseinrichtungen 301, 303 in dieser Topologie nicht durch die Induktivitäten 313, 315, 317, 319 (L3), sondern durch die Induktivitäten 305, 307, 309, 311 (L4) fließt. Diese Trennung der Ströme (AC und DC) hat Gütevorteile bei hohen Stromdichten.

Die Amplitude des Oszillationssignals zwischen den Klemmen AP und AN ist vorzugsweise größer als die Amplitude zwischen den Klemmen AP2 und AN2 und vorzugsweise größer als die Amplitude zwischen den Klemmen AP3 und AN3.

Fig. 3b zeigt einen Oszillator mit einer ersten Anregungseinrichtung 321, einer zweiten Anregungseinrichtung 323 und einer dritten Anregungseinrichtung 325, deren Strukturen jeweils der Struktur der Anregungseinrichtung aus Fig. 2 entsprechen. Jede Anregungseinrichtung 321, 323, 325 umfasst eine Transistorverstärkerschaltung mit gekoppelten Transistoren, optionalen resistiven Elementen und einer Stromquelle. Die Anregungseinrichtung 321 umfasst zwei über einen Knotenpunkt, an den ein (virtuelles) Massepotential anlegbar ist, gekoppelte Induktivitäten 327 und 329.Die Anregungseinrichtung 323 umfasst zwei über einen Knotenpunkt, an den ein (virtuelles) Massepotential anlegbar ist, gekoppelte Induktivitäten 331 und 333.Die Anregungseinrichtung 325 umfasst zwei über einen Knotenpunkt, an den ein (virtuelles) Massepotential anlegbar ist, gekoppelte Induktivitäten 335 und 337.

Der Oszillator umfasst ferner eine Schwingungserzeugungseinrichtung mit in Serie geschalteten Induktivitäten 339 und 341. Die Induktivität 339 ist über einen optionalen Widerstand mit einer Induktivität 343 gekoppelt, die über einen optionalen Widerstand mit einer Induktivität 347 gekoppelt ist. Die Induktivität 347 ist über einen optionalen Widerstand mit einem ersten Ausgang AN der Schwingungserzeugungseinrichtung gekoppelt. Die Induktivität 341 ist über einen optionalen Widerstand mit einer Induktivität 343 gekoppelt, die über einen optionalen Widerstand mit einer Induktivität 345 gekoppelt ist. Die Induktivität 345 ist mit einem zweiten Ausgang AP gekoppelt. Zwischen den Ausgängen AN und AP sind zumindest eine kapazitive Schaltung 213 umfassend zumindest zwei über einen Schalter gekoppelte Kapazitäten sowie eine Diodenschaltung umfassend zwei antiseriell geschaltete Dioden angeordnet.

Die magnetische Kopplung zwischen den Anregungseinrichtungen und der Schwingungserzeugungseinrichtung wird über die Induktivitätenpaare 327 und 339, 329 und 341, 343 und 331, 333 und 343, 345 und 335 sowie 337 und 347 realisiert.

Mit der Topologie aus Fig. 3a erhält man bei gleichen Induktivitätswerten L3=L4=L1=L2 (insgesamt bleibt die Induktivität bevorzugt konstant) sowie M=1 ungefähr die gleiche Schwingfrequenz wie mit der Struktur aus Fig. 10. Die Schwingamplitude im Tank (zwischen den Klemmen AP und AN) ist jedoch doppelt so hoch. Dabei ist die Signalamplitude an den aktiven Bauelementen (jeweils zwischen den Klemmen AP und AN) gleich wie in der Topologie aus Fig. 10. Die Werte der Induktivitäten sowie der Kopplungsfaktoren können sich jedoch von den vorstehend genannten Beispielswerten unterscheiden.

Der Topologie aus Fig. 3b liegt dasselbe Prinzip zugrunde wie der Topologie aus Fig. 3a. Im Unterschied hierzu wird jedoch eine Verdreifachung der Schwingamplitude bei gleichen Betriebsamplituden der aktiven Bauelemente erreicht.

Die in den vorstehend beschriebenen Ausführungsbeispielen erwähnten resistiven Elemente bzw. Widerstände sind optional. Bevorzugt werden die Signale in die in den Fig. 2, 3a und 3b gezeigten Induktivitäten direkt gespeist. Die dort gezeigten Widerstände können auch parasitäre Ohmsche Widerstände der Induktivitäten sein.

Die Tankamplitude A hat einen gravierenden Einfluss auf das Phasenrauchen. Eine Erhöhung dieser Amplitude gemäß den Ausführungsbeispielen 3a oder 3b verringert das Phasenrauschen, was auf die Verbesserung des Signal-zu-Rauschverhältnisses in dem schwingenden Tank, also dem Verhältnis der Schwingenergie zur Rauschenergie im Tank, zurückzuführen ist. Entgegen dem Ausführungsbeispiel der Fig. 10 wird diese Amplitude nicht auch an die aktiven Bauelemente übertragen. Hierdurch wird im Ausführungsbeispiel der Fig. 3b der überraschende Effekt erzielt, dass keine Amplitudenbegrenzung stattfindet, weil die aktiven Transistoren nicht energetisch in die Sättigung gehen.

Das obige Schwingungserzeugungskonzept des Ausführungsbeispiels der Fig. 3b hat daher folgende Wirkungen:
- Die Möglichkeit der Realisierung hoher Amplituden durch den Tank ist nicht durch die eingesetzte Technologie begrenzt. Als Beispiel sind die MOS-Technologien mit kleinen Gatelängen von 0.09µ und 0.18µ zu nennen, die technologisch bedingt einen Spannungsabfall über dem Gate von mehr als 2.5V aufgrund des Tunnelstroms oder des Durchbruchs nicht erlauben.
- Es tritt eine geringere oder keine Amplitudenbegrenzung auf, die durch die Sättigung der aktiven Bauelemente bedingt sein würde. Hierdurch wird vermindert, dass eine Umsetzung der zur Verfügung stehenden Energie auch Schwingung höherer unerwünschter Harmonischer erzeugt. Es wird also eine größere Effizienz erzielt.
- Die aktiven Bauelemente können gegenüber einem Großsignalbetrieb in einem Betrieb mit kleinerem Hub betrieben werden. Das Rauschen der Bauelemente, insbesondere das Amplitudenrauschen der aktiven Bauelemente, ist in diesem Betrieb verringert. Das Amplitudenrauschen wird gegenüber einem Großsignalbetrieb über Modulation in geringerem Maße in Phasenrauschen umgesetzt und führt damit insgesamt zu einem geringeren Phasenrauschen.

Außerdem sind die Rauschmodellierung und die allgemeine Leistungsmodellierung der aktiven Bauelemente gegenüber einem Großsignalbetrieb bedeutend einfacher, was eine Vorhersage der Phasenrausch-Eigenschaften aufgrund einer höheren Simulationsgenauigkeit vereinfacht und zu geringeren Unterschieden zwischen Simulation und Messung führt.

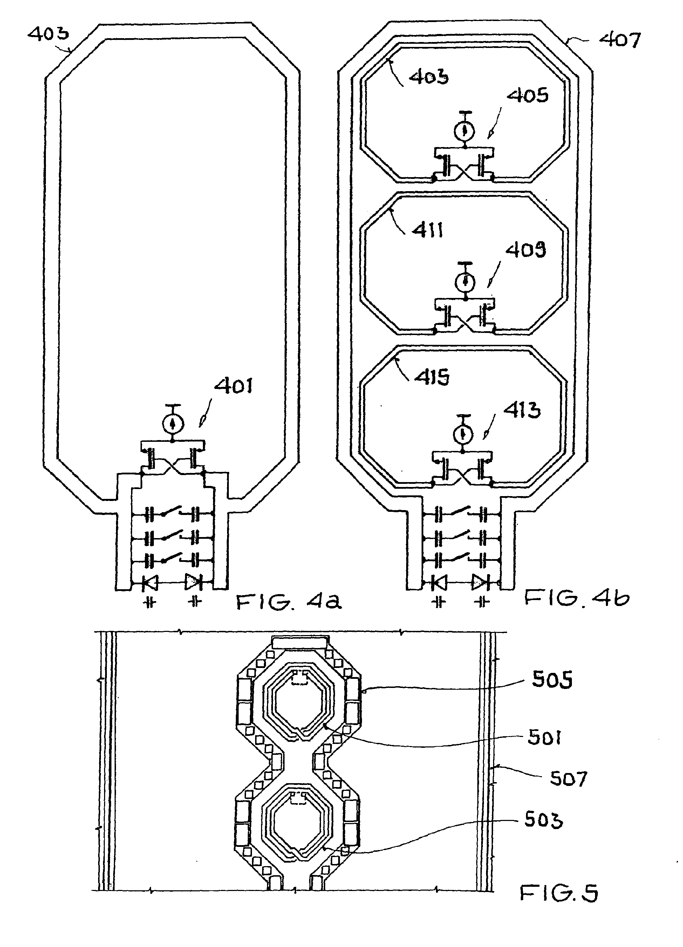

Fig. 4a zeigt eine Grundtopologie einer Oszillatoreinrichtung mit einer einen Verstärker umfassenden Anregungseinrichtung 401 sowie einer Schwingungserzeugungseinrichtung, die z.B. eine leitfähige Struktur 403, z.B. eine Streifenleitung, umfasst, die z.B. eine teilweise geschlossene Schleife bildet. Zwischen den Ausgängen der leitfähigen Struktur sind parallel die Anregungseinrichtung 401, mehrere Kapazitätsnetzwerke mit jeweils über einen Schalter verbundenen Kapazitäten sowie eine Diodenanordnung mit zwei antiseriell geschalteten Dioden geschaltet.

Fig. 4b zeigt eine Realisierung der Struktur aus Fig. 3b. Die in Fig. 4b gezeigte Struktur umfasst im Unterschied zu der Struktur aus Fig. 4a eine Mehrzahl (z.B. drei) von Anregungseinrichtungen, die innerhalb der leitfähigen Struktur 403 angeordnet sind und z.B. galvanisch voneinander getrennt sind.

Eine erste Anregungseinrichtung umfasst einen Verstärker 405, dessen Ausgänge über eine leitfähige Struktur 407, z.B. eine Streifenleitung, verbunden sind. Die leitfähige Struktur 407 ist für die magnetische Kopplung mit der Schwingungseinrichtung vorgesehen. Hierzu umfasst die leitfähige Struktur 407 beispielsweise Abschnitte, die parallel zu korrespondierenden Abschnitten der leitfähigen Struktur 403 angeordnet sind.

Eine zweite Anregungseinrichtung umfasst einen Verstärker 409, dessen Ausgänge über eine leitfähige Struktur 411, z.B. eine Streifenleitung, verbunden sind. Die leitfähige Struktur 411 ist für die magnetische Kopplung mit der Schwingungseinrichtung vorgesehen. Hierzu umfasst die leitfähige Struktur 411 beispielsweise Abschnitte, die parallel zu korrespondierenden Abschnitten der leitfähigen Struktur 403 angeordnet sind.

Eine dritte Anregungseinrichtung umfasst einen Verstärker 413, dessen Ausgänge über eine leitfähige Struktur 415, z.B. eine Streifenleitung, verbunden sind. Die leitfähige Struktur 407 ist für die magnetische Kopplung mit der Schwingungseinrichtung vorgesehen. Hierzu umfasst die leitfähige Struktur 415 beispielsweise Abschnitte, die parallel zu korrespondierenden Abschnitten der leitfähigen Struktur 403 sind.

Die Kopplung M=1 kann nur schwer realisiert werden, ohne die Güte der Induktivitäten zu beeinflussen. Sinnvolle Praxiswerte für M liegen betragsmäßig unter 0,75. Für die Bauelemente können folgende Werte eingesetzt werden: L3 = 100pH, L4 = 240pH, und M = 0,6. Ferner beträgt die Kapazität der gesamten differentiellen Kapazität z.B. 1pF. Die Resonanzfrequenz des Tanks (der Schwingungserzeugungseinrichtung) ohne die aktiven Bauelemente liegt mit den vorstehend genannten ungefähr bei z.B. 8GHz oder bei etwa 10GHz.

In Bauformen gemäß Fig. 4a oszilliert die Schaltung z.B. bei 7.46GHz. Das ist etwas niedriger als 8GHz und liegt daran, dass die aktiven Bauelemente den Tank kapazitiv belasten. Die Schwingamplitude des Tankes des erfindungsgemäßen Oszillators liegt bei 3,3V. Sie ist gleich der Amplitude der aktiven Bauelemente.

Mit der Bauform gemäß Fig. 4b oszilliert die Schaltung bei z.B. bei 7.7GHz, also mit einer etwas höheren Schwingfrequenz als bei der Topologie gemäß Fig. 4a. Der Hauptgrund hierfür ist, dass die parasitären Kapazitäten der aktiven Bauelemente eine Funktion von deren Amplituden sind. Wenn die aktiven Bauelemente bei einer kleineren Amplitude wie im Ausführungsbeispiel der Fig. 4b betrieben werden, weisen sie geringere parasitäre Kapazitäten auf, was vorteilhaft für die Abstimmbarkeit ist. Die Schwingamplitude des Tankes wie im Ausführungsbeispiel der Fig. 4b liegt z.B. bei 4,3V, während die Amplitude an den aktiven Bauelementen 2,2V beträgt. Für das Ausführungsbeispiel der Fig. 4b wird daher nahezu eine Verdopplung der Tankamplitude gegenüber der Amplitude der aktiven Bauelemente erreicht.

Fig. 5 zeigt ein Chipbild eines Oszillators mit einer ersten Anregungseinrichtung 501, einer zweiten Anregungseinrichtung 503 sowie einer Schwingungseinrichtung 505, die in Form einer leitfähigen Struktur auf einem Substrat 507 angeordnet sind. Die spiralförmig angeordneten leitfähigen Strukturen der Anregungseinrichtungen sind jeweils für die magnetische Kopplung vorgesehen. Die Anregungseinrichtungen umfassen jeweils einen Verstärker, die jeweils mit dafür vorgesehenen Anschlüssen der jeweiligen leitfähigen Struktur (z.B. Streifenleitungen) verbunden sind.

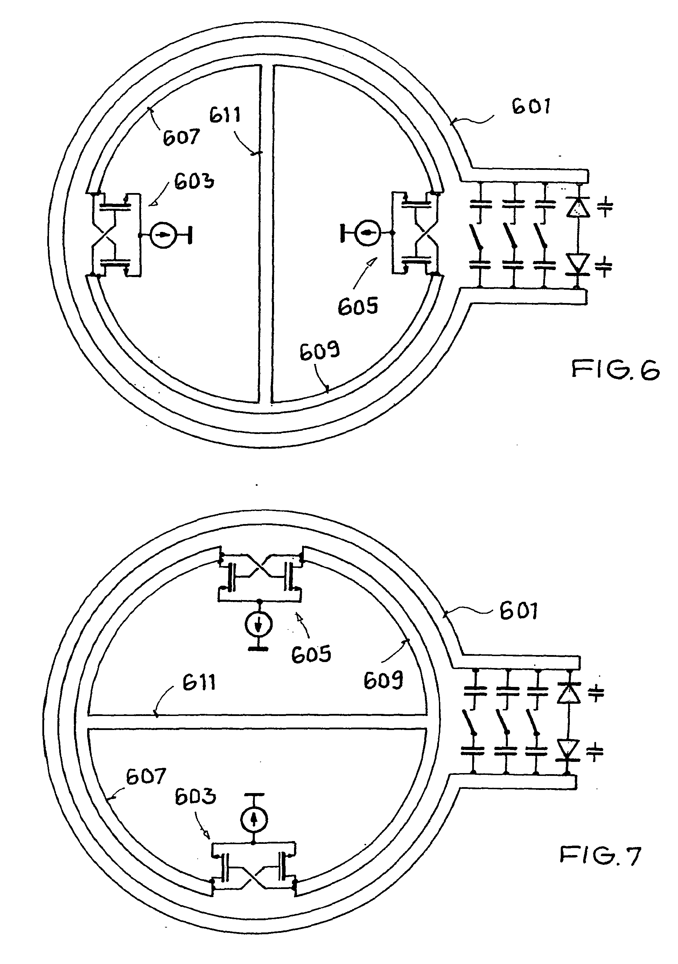

Fig. 6 zeigt einen Oszillator mit einer Schwingungserzeugungseinrichtung, die eine leitfähige Struktur 601 aufweist, z.B. eine Streifenleitung. Die Schwingungserzeugungseinrichtung umfasst ferner zumindest eine kapazitive Schaltung mit zwei über einen Schalter gekoppelten Kapazitäten sowie eine Diodenschaltung umfassend zwei antiseriell geschaltete Dioden. Die kapazitive Schaltung und die Diodenschaltung sind parallel zwischen den Anschlüssen der leitfähigen Struktur 601 angeordnet, wobei die Anschlüsse als abgewinkelte Strukturabschnitte geformt sein können.

Die Leitfähige Struktur 601 formt beispielsweise eine teilweise geschlossene Schleife, wobei innerhalb der Schleife zwei Anregungseinrichtungen mit einer ersten Verstärkerschaltung 603 und einer zweiten Verstärkerschaltung 605 angeordnet sind. Die Verstärkerschaltungen 601, 602 der zwei Anregungseinrichtungen umfassen jeweils gekoppelte Transistoren, die über eine Stromquelle gegen Masse geschaltet sind und über eine leitfähige Struktur mit einem ersten leitfähigen Abschnitt 607 und einem zweiten leitfähigen Abschnitt 609 parallel geschaltet sind. Die leitfähigen Abschnitte 607 und 609 sind über einen leitfähigen Steg verbunden. Die Enden der leitfähigen Abschnitte 607 und 609 sind jeweils gegenüber den die Anschlüsse formenden Enden 613 und 615 der Schwingungserzeugungseinrichtung angeordnet, an denen auch das Oszillationssignal bereitgestellt werden kann. Die leitfähigen Abschnitte 607 und 609 sind jeweils für die magnetische Kopplung mit der leitfähigen Struktur 601 vorgesehen.

Mit der in Fig. 6 dargestellten Struktur kann die magnetische Kopplung bei optimiertem Flächenverbrauch erreicht werden.

Fig. 7 zeigt den Oszillator aus Fig. 6 mit zwei um 90 Grad gedrehten Anregungsvorrichtungen. Der Steg 611 und die Anschlussbereiche 613 und 615 sind dabei parallel angeordnet. Durch das Ausführungsbeispiel der Fig. 7 wird eine verbesserte kapazitive Belastung erreicht.

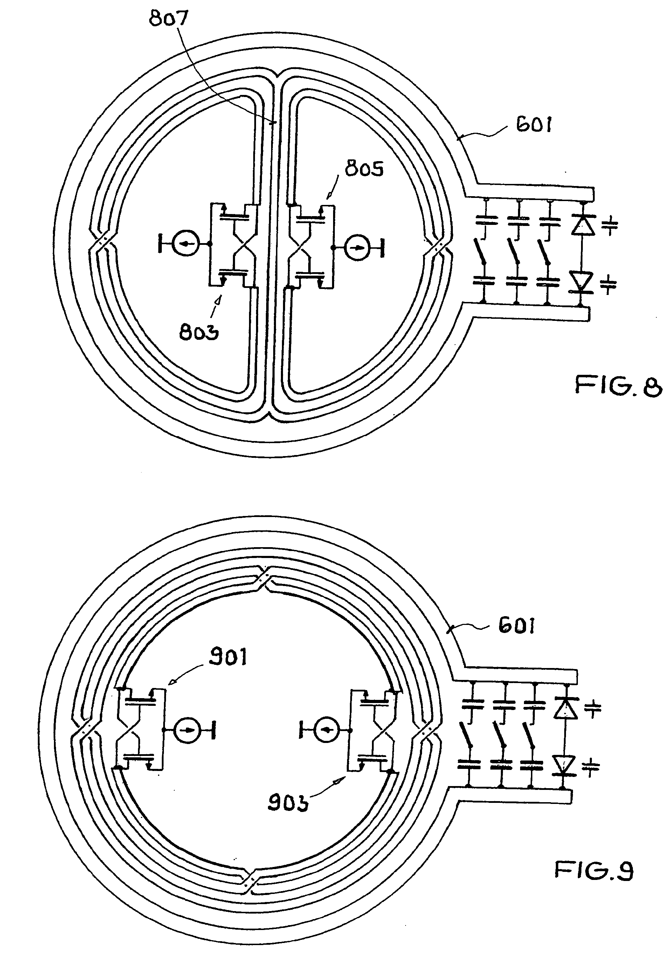

Fig. 8 zeigt einen Oszillator mit zwei Anregungseinrichtungen, die innerhalb der durch die leitfähige Struktur 601 zumindest teilweise gebildeten Schleife angeordnet sind. Jede Anregungseinrichtung umfasst eine leitfähige Struktur sowie ein Transistorverstärkerschaltung 803 beziehungsweise 805, die mittels der leitfähigen Struktur parallel geschaltet sind. Die Anschlüsse der Transistorverstärkerschaltungen 803 und 805 sind jeweils über verdrillte leitfähige Strukturen gekoppelt, die über einen zwischen den Verstärkerschaltungen 803 und 805 verlaufenden Steg 807 verbunden sind. Im Ausführungsbeispiel der Fig. 8 kann jeder Transistor in seinem optimalen Leistungsarbeitspunkt betrieben werden. Der Einfluss von Rauschen, Verzerrungen, Temperatur und Substrateffekten ist gegenüber dem Ausführungsbeispiel der Fig. 10 reduziert. Dennoch kann eine große Signalamplitude erzielt werden.

Fig. 9 zeigt einen Oszillator mit zwei Anregungseinrichtungen, die innerhalb der durch die leitfähige Struktur 601 zumindest teilweise gebildeten Schleife angeordnet ist. Jede Anregungseinrichtung umfasst eine Transistorverstärkerschaltung 901 beziehungsweise 903, wobei die Transistorverstärkerschaltungen 901 und 903 mittels einer leitfähigen Struktur parallel geschaltet sind. Die Anschlüsse der Transistorverstärkerschaltungen 901 und 905 sind jeweils über verdrillte leitfähige Strukturen gekoppelt, die sie sich konzentrisch und spiralförmig erstrecken und auch für die magnetische Kopplung mit der leitfähigen Struktur 601 vorgesehen sind. Bei der Topologie des Ausführungsbeispiel der Fig. 9 wird eine höhere Induktivität für die aktiven Bauelemente erreicht.

Die leitfähigen Strukturen können z.B. als Streifenleitungen oder Mikrostreifenleitungen ausgebildet sein.

Durch das Ausführungsbeispiel der Fig. 9 werden folgende z.T. überraschende Wirkungen erzielt:
- Die Realisierung hoher Tankamplituden ist nicht mehr von der Technologie begrenzt,
- Die Versorgungsspannung begrenzt die Amplitude nicht,
- Die aktiven Bauelemente arbeiten nicht im Größtsignalbetrieb,
- kleinere parasitären Kapazitäten der aktiven Bauelemente,
- geringeres Amplitudenrauschen im Großsignalbetrieb,
- geringeres Amplitudenrauschen, denn C_{Aktiv} ist eine Funktion der Amplitude
- bessere Abstimmbarkeit durch eine Abstimmung der Kapazitäten,
- höhere harmonische Unterdrückung aufgrund der kleineren Betriebsamplitude der aktiven Bauelemente,
- höhere harmonische Unterdrückung insbesondere der dritten Harmonischen aufgrund der Energieübertragung über die magnetische Kopplung,
- die Rauschmodellierung und die allgemeine Leistungsmodellierung der aktiven Bauelemente in diesen Amplitudebetrieb sind einfach, was eine Vorhersage der PN-Eigenschaften durch Simulationen erleichtert,
- Gütevorteile bei hohen Stromdichten, und
- geringer Flächenverbrauch.

Ein Oszillator gemäß den Ausführungsbeispielen kann beispielsweise in einem Datenübertragungssystem gemäß IEEE 802.16 ("WiMax", Worldwide Interoperability for Microwave Access) eingesetzt werden.

Eine Sende-/Empfangsvorrichtung weist in diesem System eine Antenne sowie eine mit der Antenne verbundene Sende-/Empfangseinheit (Transceiver) auf. Die Sende-/ Empfangseinheit beinhaltet eine mit der Antenne verbundene HF-Frontend-Schaltung sowie eine nachgeschaltete IF/BB-Signalverarbeitungseinheit. Weiterhin beinhaltet die Sende-/ Empfangseinheit einen mit der Antenne verbundenen Sendepfad.

Die HF-Frontend-Schaltung verstärkt ein von der Antenne empfangenes hochfrequentes Funksignals, das spektral im Mikrowellenbereich zwischen 3,4 und 3,6 GHz liegt, und überführt (transformiert) es in ein Quadratursignal in einem Zwischenfrequenzbereich (Intermediate Frequency, IF) oder im Basisbandbereich ("zero IF"). Beim Quadratursignal handelt es sich um ein komplexwertiges Signal mit einer Inphase-Komponente und einer Quadraturphasen-Komponente.

Die IF/BB-Signalverarbeitungseinheit filtert das Quadratursignal und verschiebt es evtl. spektral ins Basisband, demoduliert das Basisbandsignal und detektiert die darin enthaltenen und ursprünglich von einer anderen Sende-/Empfangsvorrichtung gesendeten Daten.

Die HF-Frontend-Schaltung weist einen mit der Antenne verbundenen Verstärker (Low Noise Amplifier, LNA) zum Verstärken des hochfrequenten Funksignals und einen nachgeschalteten Quadraturmischer zum Überführen des verstärkten Signals in das Quadratursignal auf. Weiterhin weist die HF-Frontend-Schaltung eine Schaltungsanordnung und einen nachgeschalteten I/Q-Generator auf, der ausgangsseitig mit dem Quadraturmischer verbunden ist.

Die Schaltungsanordnung beinhaltet einen spannungsgesteuerten Oszillator (VCO) gemäß der Erfindung, dessen Frequenz mit Hilfe von Steuerspannungen relativ grob eingestellt und mit Hilfe weiterer (ggf. PLL-geregelter) Steuerspannungen fein abgestimmt wird.

Der I/Q-Generator leitet aus dem Lokaloszillatorsignal der Schaltungsanordnung ein differentielles Inphase-Signal und ein um 90 Grad phasenverschobenes differentielles Quadraturphase-Signal ab. Ggf. beinhaltet der I/Q-Generator einen Frequenzteiler, Verstärkungselemente und/oder eine Einheit, die sicherstellt, dass der Phasenversatz der Signale und möglichst genau 90 Grad beträgt.

In weiteren vorteilhaften Ausführungsformen weist die HF-Frontend-Schaltung im Sendepfad einen Verstärker (Power Amplifier) auf.

Die HF-Frontend-Schaltung und damit die mindestens eine erfindungsgemäße Schaltungsanordnung sowie evtl. Teile der IF/BB-Signalverarbeitungseinheit sind vorzugsweise Bestandteil einer integrierten Schaltung (integrated circuit, IC), die z.B. als monolithisch integrierte Schaltung in einer Standard-Technologie, beispielsweise in einer BiCMOS-Technologie, als Hybridschaltung (Dünn- bzw. Dickschichttechnologie) oder als Multilayer-Keramik-Schaltung ausgebildet ist.

Die anhand von Ausführungsbeispielen vorstehend beschriebene erfindungsgemäße Schaltungsanordnung ist nicht auf diese Ausführungsbeispiele beschränkt und kann in unterschiedlichsten Anwendungen wie z.B. in Oszillator-, Verstärker- und Filter-Schaltungen (einstellbare Übertragungsfunktion, Bandbreite etc.) vorteilhaft eingesetzt werden.

### Bezugszeichenliste

- 101: Anregungseinrichtung
- 103: Schwingungserzeugungseinrichtung
- 105: Induktivität
- 107: Induktivität
- 201: Anregungseinrichtung
- 203: Induktivität
- 205: Induktivität
- 207: Transistorverstärkerschaltung
- 209: Induktivität
- 211: Induktivität
- 213: kapazitives Netzwerk
- 301: Anregungseinrichtung
- 303: Anregungseinrichtung
- 305: Induktivität
- 307: Induktivität
- 309: Induktivität
- 311: Induktivität
- 313: Induktivität
- 315: Induktivität
- 317: Induktivität
- 319: Induktivität
- 321: Anregungseinrichtung
- 323: Anregungseinrichtung
- 325: Anregungseinrichtung
- 327: Induktivität
- 329: Induktivität
- 331: Induktivität
- 333: Induktivität
- 335: Induktivität
- 337: Induktivität
- 339: Induktivität
- 341: Induktivität
- 343: Induktivität
- 345: Induktivität
- 401: Anregungseinrichtung
- 403: leitfähige Struktur
- 405: Verstärker
- 407: leitfähige Struktur
- 409: Verstärker
- 411: leitfähige Struktur
- 413: Verstärker
- 415: leitfähige Struktur
- 501: Anregungseinrichtung
- 503: Anregungseinrichtung
- 505: Schwingungseinrichtung
- 507: Substrat
- 601: leitfähige Struktur
- 603: Verstärkerschaltung
- 605: Verstärkerschaltung
- 607: leitfähiger Abschnitt
- 609: leitfähiger Abschnitt
- 611: Steg
- 613: Anschluss
- 615: Anschluss
- 803: Transistorverstärkerschaltung
- 805: Transistorverstärkerschaltung
- 807: Steg
- 901: Transistorverstärkerschaltung
- 903: Transistorverstärkerschaltung

## Patentansprüche

1. Oszillator, mit:
- einer Mehrzahl von Anregungseinrichtungen (301, 303, 321, 323, 325, 501, 503) zum Bereitstellen eines Anregungssignals und
- einem Tank als Schwingungserzeugungseinrichtung zum Erzeugen eines Oszillationssignals ansprechend auf das Anregungssignal,
- wobei der Tank Anschlüsse (AN, AP) zum Bereitstellen des Oszillatorsignals aufweist,
- wobei jede Anregungseinrichtung (301, 303, 321, 323, 325, 501, 503) zumindest eine Induktivität (L4, L6) aufweist,
- wobei der Tank mit der zumindest einen Induktivität (L4, L6) jeder Anregungseinrichtungen (301, 303, 321, 323, 325, 501, 503) magnetisch gekoppelt ist,
- wobei das Anregungssignal zwischen den Anregungseinrichtungen (301, 303, 321, 323, 325, 401, 501) und dem Tank mittels der magnetischen Kopplungen übertragbar ist.

2. Oszillator gemäß Anspruch 1, wobei jede Anregungseinrichtung (301, 303, 321, 323, 325, 501, 503) und die Schwingungserzeugungseinrichtung galvanisch getrennt sind oder an zumindest einem Knotenpunkt verbunden sind, bei dem beim Betrieb des Oszillators ein konstantes Potential, insbesondere eine virtuelle Masse, herrscht.

3. Oszillator gemäß einem der Ansprüche 1 oder 2, wobei jede Anregungseinrichtung (301, 303, 321, 323, 325, 501, 503) einen Verstärker mit zumindest einer Induktivität umfasst, die für die magnetische Kopplung mit zumindest einer Induktivität (L3, L5) des Tanks vorgesehen ist.

4. Oszillator gemäß einem der Ansprüche 1 bis 3, wobei der Tank zur Abstimmung einer Schwingfrequenz des Oszillatorsignals ausgebildet ist.

5. Oszillator gemäß einem der Ansprüche 1 bis 4, wobei die Anschlüsse (AN, AP) zum Bereitstellen des Oszillatorsignals von jeder Anregungseinrichtung (301, 303, 321, 323, 325, 501, 503) galvanisch getrennt sind oder an zumindest einem Knotenpunkt verbunden sind, bei dem beim Betrieb des Oszillators ein konstantes Potential, insbesondere eine virtuelle Masse, herrscht.

6. Oszillator gemäß einem der Ansprüche 1 bis 5, wobei jede Anregungseinrichtung (301, 303, 321, 323, 325, 501, 503) eine Transistorverstärkerschaltung, eine erste Induktivität und eine zweite Induktivität aufweist, wobei die erste und die zweite Induktivität mit der Transistorverstärkerschaltung verbunden sind, wobei der Tank eine dritte Induktivität und eine vierte Induktivität aufweist, wobei die erste und die dritte Induktivität angeordnet sind, um eine erste magnetische Kopplung bereitzustellen, und wobei die zweite und die vierte Induktivität angeordnet sind, um eine zweite magnetische Kopplung bereitzustellen.

7. Oszillator gemäß Anspruch 6, wobei die erste und die zweite Induktivität über einen Knotenpunkt verbunden sind, an den ein Potential anlegbar ist, und wobei die dritte und die vierte Induktivität in Serie geschaltet sind.

8. Oszillator gemäß einem der Ansprüche 1 bis 7, wobei jede Anregungseinrichtung zumindest eine Verstärkerschaltung umfasst, wobei die Verstärkerschaltung einen ersten Transistor und einen zweiten Transistor umfasst, wobei ein erster Anschluss des ersten Transistors mit einem Steueranschluss des zweiten Transistors verbunden ist und wobei ein erster Anschluss des zweiten Transistors mit einem Steueranschluss des ersten Transistors verbunden ist.

9. Oszillator gemäß Anspruch 8, bei dem der erste Anschluss des ersten Transistors mit einer ersten Induktivität der jeweiligen Anregungseinrichtung (301, 303, 321, 323, 325, 501, 503) verbunden ist, bei dem der zweite Anschluss des zweiten Transistors mit einer zweiten Induktivität der jeweiligen Anregungseinrichtung (301, 303, 321, 323, 325, 501, 503) verbunden ist, und bei dem die zweiten Anschlüsse des ersten und des zweiten Transistors miteinander verbunden sind.

10. Oszillator gemäß einem der Ansprüche 1 bis 9, der abstimmbar ist, wobei der Tank oder eine Anregungseinrichtung (301, 303, 321, 323, 325, 501, 503) abstimmbare Induktivitäten oder Kapazitäten aufweisen.

11. Oszillator gemäß einem der Ansprüche 1 bis 10, wobei jede Anregungseinrichtung (301, 303, 321, 323, 325, 501, 503) eine erste leitfähige Struktur, insbesondere eine Streifenleitung, umfasst, wobei der Tank eine zweite leitfähige Struktur umfasst, und wobei die erste und die zweite leitfähige Struktur angeordnet sind, die magnetische Kopplung bereitzustellen.

12. Oszillator gemäß einem der Ansprüche 1 bis 11, wobei jede Anregungseinrichtung (301, 303, 321, 323, 325, 501, 503) eine erste leitfähige Struktur umfasst, die von einer zweiten leitfähigen Struktur des Tanks zumindest teilweise umschlossen ist.

13. Oszillator gemäß einem der Ansprüche 1 bis 12, wobei der Tank zumindest eine leitfähige Struktur umfasst, die zumindest eine leitfähige Struktur jeder Anregungseinrichtung (301, 303, 321, 323, 325, 501, 503) für die magnetische Kopplung zumindest teilweise umschließt.

14. Oszillator gemäß einem der Ansprüche 11 bis 13, wobei die leitfähigen Strukturen jeder Anregungseinrichtung (301, 303, 321, 323, 325, 501, 503) galvanisch getrennt oder an zumindest einem Knotenpunkt, an dem beim Betrieb des Oszillators virtuell ein konstantes Potential, insbesondere virtuelle Masse, herrscht, verbunden sind.

15. Verwendung einer Mehrzahl von Anregungseinrichtungen (301, 303, 321, 323, 325, 501, 503) eines Oszillators zum Bereitstellen eines Anregungssignals aus der Summe von Anregungsenergien der einzelnen Anregungseinrichtungen (301, 303, 321, 323, 325, 501, 503)
- mit einem Tank als Schwingungserzeugungseinrichtung zum Erzeugen eines Oszillationssignals ansprechend auf das Anregungssignal,
- wobei der Tank Anschlüsse (AN, AP) zum Bereitstellen des Oszillatorsignals aufweist,
- wobei jede Anregungseinrichtung (301, 303, 321, 323, 325, 501, 503) zumindest eine Induktivität (L4, L6) aufweist,
- wobei der Tank mit der zumindest einen Induktivität (L4, L6) jeder Anregungseinrichtungen (301, 303, 321, 323, 325, 501, 503) magnetisch gekoppelt ist,
- wobei das Anregungssignal zwischen den Anregungseinrichtungen (301, 303, 321, 323, 325, 401, 501) und dem Tank mittels der magnetischen Kopplungen übertragbar ist.
